Europäisches Patentamt

European Patent Office

Office européen des brevets

(11) Veröffentlichungsnummer: **0 026 455**
**A2**

(19)

(12) **EUROPÄISCHE PATENTANMELDUNG**

(21) Anmeldenummer: **80105754.8**

(22) Anmeldetag: **24.09.80**

(51) Int. Cl.³: **H 01 G 1/147**

(30) Priorität: **26.09.79 DE 2938954**

(43) Veröffentlichungstag der Anmeldung:
**08.04.81 Patentblatt 81/14**

(84) Benannte Vertragsstaaten:
**FR GB IT SE**

(71) Anmelder: **SIEMENS AKTIENGESELLSCHAFT Berlin und München**
**Postfach 22 02 61**
**D-8000 München 22(DE)**

(72) Erfinder: **Kraus, Hubert, Ing. grad.**
**Agnesstrasse 11**
**D-8400 Regensburg(DE)**

(54) **Verfahren und Vorrichtung zum Anlöten von Anschlussdrähten auf elektrische Bauelemente.**

(57) Verfahren und Vorrichtung zum Anlöten von Anschlußdrähten auf elektrische Bauelemente.

In Stirnkontaktschichten (9) aus Lotmetall auf elektrischen Bauelementen (12) werden Anschlußdrähte (3) angelötet, indem sie durch zwei Elektroden (1, 2) aufgedrückt, kontaktiert und durch den nun fließenden Strom erhitzt und in die
Stirnkontaktschichten eingedrückt werden. Um Material einzusparen, wird vorgeschlagen, die Anschlußdrähte (3) entlang der gesamten einzuschmelzenden Ausdehnung zu kontaktieren, gleichmäßig zu erhitzen und in die Stirnkontaktschicht (9) einzudrücken. Dieses Verfahren eignet sich zur
Kontaktierung von Kondensatoren, deren Dielektrika aus
Kunststoffolien und deren Beläge aus regenerierfähig dünnen
Metallisierungen bestehen.

Anwendung in Kondensatoren mit Kunststoffolien und
Schoopschichten.

FIG1

SIEMENS AKTIENGESELLSCHAFT          Unser Zeichen
Berlin und München                  VPA 79 P 1 1 6 0 EUR

Verfahren und Vorrichtung zum Anlöten von Anschlußdrähten
auf elektrische Bauelemente.

Die vorliegende Erfindung betrifft ein Verfahren zum Anlöten von Anschlußdrähten auf elektrische Bauelemente,
insbesondere elektrische Kondensatoren mit Kunststoffolien als Dielektrika, regenerierfähig dünnen Belägen und
mit Stirnkontaktschichten aus Lotmetall, bei dem ein Anschlußdraht über die Stirnkontaktschicht gebracht wird,
bei dem zwei Elektroden auf den Anschlußdraht aufgedrückt
werden und bei dem der Anschlußdraht der Elektroden kontaktiert und durch einen elektrischen Strom erhitzt und
in das dadurch schmelzende Lot eingedrückt wird.

Ein derartiges Verfahren ist aus dem DE-GM 66 10 477 bekannt. Gemäß diesem Verfahren werden Anschlußdrähte an
zwei Stellen, die in Achsrichtung des Drahtes hintereinander liegen, durch Elektroden kontaktiert und in das
Lotmetall eingeschmolzen.

Die Aufgabe, die der vorliegenden Erfindung zugrundeliegt,

Mhs 1 Lk  / 25.9.1979

besteht in einer gleichmäßigen, einwandfreien Kontaktierung von Kondensatoren durch Anschlußdrähte, die den
Einsatz von dünneren Stirnkontaktschichten zuläßt.

Diese Aufgabe wird bei einem Verfahren der eingangs beschriebenen Art dadurch gelöst, daß die Kontaktflächen
der Elektroden so auf den Draht gedrückt werden, daß sie
den Draht zumindest teilweise entlang seiner Mantellinien
derart berühren, daß diese Mantellinien mit der Symmetrieachse des Drahtes einen Zylinder mit dreieckigem Querschnitt bilden.

Durch diese Anordnung erfolgt der Stromdurchgang in zur
Drahtachse senkrechten Richtungen, es ergibt sich somit eine von der Drahtlänge unabhängige Erwärmung des
Anschlußdrahtes. Gleichzeitig wird der Druck auf den gesamten einzuschmelzenden Teil des Drahtes gleichmäßig
ausgeübt, wodurch eine gleichmäßige Erhitzung und ein
gleichmäßiges Einschmelzen des Drahtes möglich ist.

Vorteilhaft wird der Draht durch die Elektroden so weit
in das Lotmetall eingedrückt, daß das schmelzende Lotmetall am Draht hochsteigt und die Zwischenräume zwischen
den Kontaktflächen und dem Draht bis zu den Berührungslinien zwischen dem Draht und den Kontaktflächen ausfüllt.
Dadurch ergibt sich ein Umschließen des Drahtes mit Lotmetall, welches eine verbesserte Kontaktierung und mechanische Halterung des Drahtes bewirkt, ohne daß die Lotmetallschicht dicker gestaltet zu werden braucht. Das
Verfahren läßt sich vorteilhaft für die Kontaktierung
auf Spritzmetallschichten anwenden, die nach dem Schoop'-
schen Flammspritzverfahren hergestellt sind.

Die Eindringtiefe des Anschlußdrahtes wird vorteilhaft
durch die dem Bauelement zugewandten Stirnflächen der Elektroden begrenzt, indem der Anschlußdraht soweit in die Stirnkontaktschicht eingedrückt wird, daß die Stirnflächen der Elektroden auf den Stirnkontaktschichten des Bauelementes aufliegen. Somit kann der Draht je nach Ausbildung der Elektroden bis zu einer genau vorherbestimmbaren Eindringtiefe eingedrückt werden. Die Stirnkontaktschicht und der darunterliegende Kondensator werden dadurch nur einer geringen Flächenbelastung ausgesetzt. Ein unerwünschtes Durchbrechen des Drahtes in den Kondensator wird vermieden.

Eine vorteilhafte Vorrichtung zur Durchführung des vorgeschlagenen Verfahrens, welche Elektroden mit Kontaktflächen enthält, wobei die Elektroden auf den Anschlußdraht aufgedrückt werden können, weist die Merkmale auf, daß die Kontaktflächen der Elektroden gegeneinander geneigt sind und zu dem Draht hin sich voneinander entfernen und daß sich die Projektionen der Kontaktflächen in der zu ihrer Bewegungsrichtung (A) und zur Drahtachse senkrechten Richtung zumindest teilweise überlappen. Eine besonders feste mechanische Halterung der Drähte in den Stirnkontaktschichten wird erreicht, indem die Elektroden in der Richtung der Drahtachse hintereinander angeordnete Ausnehmungen aufweisen, in welche Lotmetall zur Bildung einer festen Halterung für die Drähte einfließen kann. Nach dem Erkalten des Lotmetalls bilden sich so bügelförmige Halterungen für den Anschlußdraht. Die Ausnehmungen sind vorteilhaft durch rechteckförmige Nuten gebildet, welche von den dem Kondensator zugewandten Stirnflächen der Elektroden ausgehen.

Die Erfindung wird nun anhand von zwei Figuren näher erläutert. Sie ist nicht auf das in den Figuren gezeigte Beispiel beschränkt.

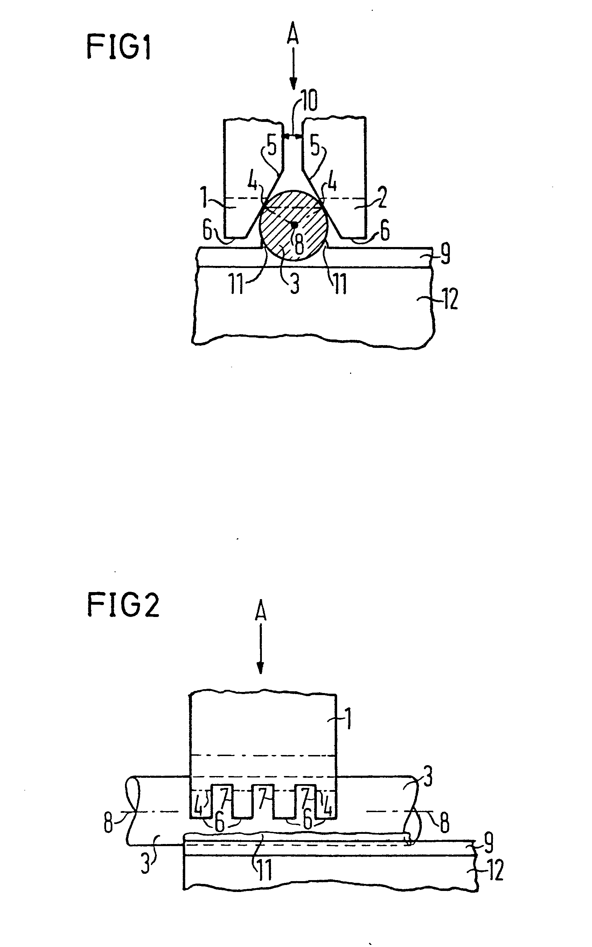

Fig. 1 zeigt eine erfindungsgemäße Vorrichtung aus einer Blickrichtung, die mit der Laufrichtung des Drahtes zusammenfällt.

Fig. 2 zeigt dieselbe Vorrichtung aus einer Blickrichtung senkrecht zur Laufrichtung des Drahtes.

Zwei Elektroden 1 und 2 drücken einen Draht 3 in Pfeilrichtung A gegen eine Stirnkontaktschicht 9 eines Bauelementes 12. Dabei kontaktieren die Kontaktflächen 5 der Elektroden 1, 2 den Anschlußdraht 3 in Kontaktlinien 4, welche Mantellinien des Anschlußdrahtes 3 entsprechen. Die Kontaktlinien 4 bilden mit der Drahtachse 8 einen Zylinder mit dreieckigem Querschnitt, dessen Höhe durch die gegenseitige Lage der Elektroden 1 und 2 in Richtung der Achse 8 gegeben ist. Die Stirnflächen 6 der Elektroden 1 und 2 begrenzen die Eindringtiefe des Anschlußdrahtes 3 in die Stirnkontaktschicht 9 des Bauelementes. Die Eindringtiefe kann beispielsweise durch den Abstand 10 zwischen den Elektroden 1 und 2 eingestellt werden.

Die Elektroden 1 und 2 weisen Ausnehmungen 7 auf, welche von den Stirnseiten 6 ausgehen und die Form von Nuten besitzen. In diese Ausnehmungen 7 kann das aufsteigende Lotmetall 11 beim Einschmelzen der Anschlußdrähte eindringen. Das Lotmetall bildet dadurch Halteklammern, welche den Anschlußdraht 3 zumindest *umfassen. So wird eine besonders sichere mechanische Halterung und ein einwandfreier Kontakt auch bei starker mechanischer Belastung gewährleistet.

*teilweise

6 Patentansprüche

2 Figuren

Patentansprüche

1. Verfahren zum Anlöten von Anschlußdrähten auf elektrische Bauelemente, insbesondere elektrische Kondensatoren mit Kunststoffolien als Dielektrika und regenerierfähig dünnen Belägen und mit Stirnkontaktschichten aus Lotmetall, bei dem ein Anschlußdraht über die Stirnkontaktschicht gebracht wird, bei dem zwei Elektroden auf den Anschlußdraht aufgedrückt werden, der Anschlußdraht durch Kontaktflächen der Elektroden kontaktiert und durch einen Strom erhitzt und in das dadurch schmelzende Lot eingedrückt wird, d a d u r c h   g e k e n n z e i c h n e t, daß die Kontaktflächen der Elektroden so auf den Anschlußdraht gedrückt werden, daß sie den Anschlußdraht zumindest entlang seiner Mantellinien derart berühren, daß diese Mantellinien mit der Symmetrieachse des Drahtes einen Zylinder mit dreieckigem Querschnitt bilden.

2. Verfahren nach Anspruch 1, d a d u r c h   g e k e n n z e i c h n e t, daß der Anschlußdraht durch die Elektroden so weit in das Lotmetall eingedrückt wird, daß das schmelzende Lotmetall am Draht hochsteigt und die Zwischenräume zwischen den Kontaktflächen und dem Anschlußdraht bis zu den Berührungslinien zwischen dem Anschlußdraht und den Kontaktflächen ausfüllt.

3. Verfahren nach einem der Ansprüche 1 oder 2, d a durch   g e k e n n z e i c h n e t, daß der Anschlußdraht so weit in die Stirnkontaktschicht eingedrückt wird, daß die Stirnflächen der Elektroden auf den Stirnkontaktschichten des Bauelementes aufliegen.

4. Vorrichtung zur Durchführung des Verfahrens nach einem der Ansprüche 1 bis 3, welche Elektroden mit Kontaktflächen enthält, wobei die Elektroden auf den An-

schlußdraht aufgedrückt werden können, d a d u r c h g e k e n n z e i c h n e t , daß die Kontaktfkächen der Elektroden gegeneinander geneigt sind und zu dem Draht hin sich voneinander entfernen und daß sich die Projektionen der Kontaktflächen in der zu ihrer Bewegungsrichtung (A) und zur Drahtachse senkrechten Richtung zumindest teilweise überlappen.

5. Vorrichtung nach Anspruch 4, d a d u r c h g e - k e n n z e i c h n e t , daß die Elektroden in der Richtung der Drahtachse hintereinander angeordnete Ausnehmungen aufweisen, in welche das Lotmetall unter Bildung einer festen Halterung für die Drähte einfließen kann.

6. Vorrichtung nach Anspruch 5, d a d u r c h g e - k e n n z e i c h n e t , daß die Ausnehmungen als Nuten ausgebildet sind, welche in die dem Kondensator zugewandten Stirnflächen der Elektroden eingefräst sind.

FIG1

FIG2